(19) Europäisches Patentamt

European Patent Office

Office européen des brevets

(11) EP 0 901 058 A1

(12) EUROPEAN PATENT APPLICATION

(43) Date of publication:
10.03.1999 Bulletin 1999/10

(51) Int. Cl.$^6$: G05F 3/26

(21) Application number: 98115076.6

(22) Date of filing: 29.10.1992

(84) Designated Contracting States:
DE FR GB IT

(30) Priority: 30.10.1991 US 785325
30.10.1991 US 785395
30.10.1991 US 785400

(62) Document number(s) of the earlier application(s) in
accordance with Art. 76 EPC:
92924194.1 / 0 610 430

(71) Applicant: HARRIS CORPORATION
Melbourne, FL 32901 (US)

(72) Inventors:
• Bacrania, Kantilal
N.E., Palm Bay,FL 32903 (US)

• Chi, Chong In
Santa Clara, CA 95051 (US)
• Fisher, Gregory James
Indialantic, FL 32903, (US)

(74) Representative:
Schmidt, Steffen J., Dipl.-Ing.
Wuesthoff & Wuesthoff,
Patent- und Rechtsanwälte,
Schweigerstrasse 2
81541 München (DE)

Remarks:
This application was filed on 11 - 08 - 1998 as a
divisional application to the application mentioned
under INID code 62.

(54) Two stage current mirror

(57) An A-to-D converter 300 has a comparator 126 with a number of comparator cells 902. Each comparator cell 902 includes a current mirror 1700 that reduces kickback noise. Current mirror 1700 includes a bipolar current mirror 1705 and an NMOS current mirror 1709. The bipolar current mirror 1705 provides as ac ground paralleling NMOS transistor 1704 in the NMOS current mirror 1709 to reduce kickback noise.

FIG. 17

## Description

TECHNICAL FIELD

The present invention relates to electronic semiconductor devices and methods of fabrication, and, more particularly, to semiconductor devices useful for conversion between analog and digital signals and fabrication methods integrating both bipolar and field effect devices.

BACKGROUND AND SUMMARY OF THE INVENTION

Digital processing and transmission of electrical signals has become commonplace even for basically analog information. Examples range from handheld digital voltmeters to the transition beginning in the 1960s of the public long distance telephone network from analog transmission to pulse code modulation (PCM) digital transmission. Application of digital methods to analog information requires an analog-to-digital (A/D) conversion, and the linearity, resolution, and speed of such conversion depends upon the application. For example, digital voltmeters usually call for A/D conversion with good linearity and resolution (18-bits) but which may be slow (1 Hz); whereas, video applications demand high speed (30 million samples and conversions per second) but tolerate low resolution (8-bits) and poor linearity. Intermediate requirements of 12-bit resolution, good linearity, and 3 Msps (million samples per second) speed appear in applications such as medical imaging with ultrasound, robotic control, high speed data acquisition, process control, radar signal analysis, disk drive head control, vibration analysis, waveform spectral analysis, and so forth. Multichannel information acquisition with arrays of A/D converters leads to another requirement: small aperture jitter so that synchronism of the channels can be maintained.

Well known types of A/D converters include the successive approximations converter which produces a digital output by a succession of trial-and-error steps using a digital-to-analog converter (DAC) and the flash converter which compares an input signal to multiple reference levels simultaneously and outputs a digital version of the closest reference level in a single step. The successive approximations converter provides high resolution and linearity but with low conversion speed, and the flash supplies high speed at the cost of resolution and linearity. Note that a flash converter with n-bit resolution typically has a voltage divider with $2^n$ taps and $2^n$ comparators, and this becomes unwieldy for high resolution. See, however, copending U.S. patent application Ser. No. 696,241, filed May 6, 1991 and assigned to the assignee of the present application. A compromise between these two types is the two-step flash A/D converter which uses a first coarse flash conversion to find the most significant bits and then reconstructs an analog signal from first flash output and subtracts this from the input signal to create an error signal from which a second flash conversion finds the least significant bits. Generally see Grebene, *Bipolar and MOS Analog Integrated Circuit Design* (Wiley-Interscience 1984), page 871. Generally, it is desirable that A/D converters combine still higher speed and resolution with lower noise.

Methods of fabrication used for various semiconductor devices include the combination of bipolar transistors with CMOS transistors (BiCMOS), with analog portions of the integrated circuit using bipolar transistors for their low noise and digital portions using CMOS transistors for their high packing density. See for example R.Haken et al, "BiCMOS Processes for Digital and Analog Devices," Semiconductor International 96 (June 1989). However, improved BiCMOS fabrication methods are needed to achieve higher speed and resolution with lower noise on a monolithic circuit.

The present invention provides a monolithic two-step flash A/D converter with high speed and resolution and a BiCMOS method of fabrication applicable to such converters and other integrated circuits.

BRIEF DESCRIPTION OF THE DRAWINGS

The present invention will be described with reference to the accompanying drawings which are schematic for clarity,

> Figures 1-2 illustrate applications of a preferred embodiment analog-to-digital converter;
> Figure 3 is a functional block circuit diagram of the preferred embodiment;
> Figures 4-5 are flow and timing diagrams for the operation of the preferred embodiment;
> Figures 6-8 show aspects of the sample and hold of the preferred embodiment;
> Figures 9-22 show aspects of the flash converter of the preferred embodiment;

DESCRIPTION OF THE PREFERRED EMBODIMENTS

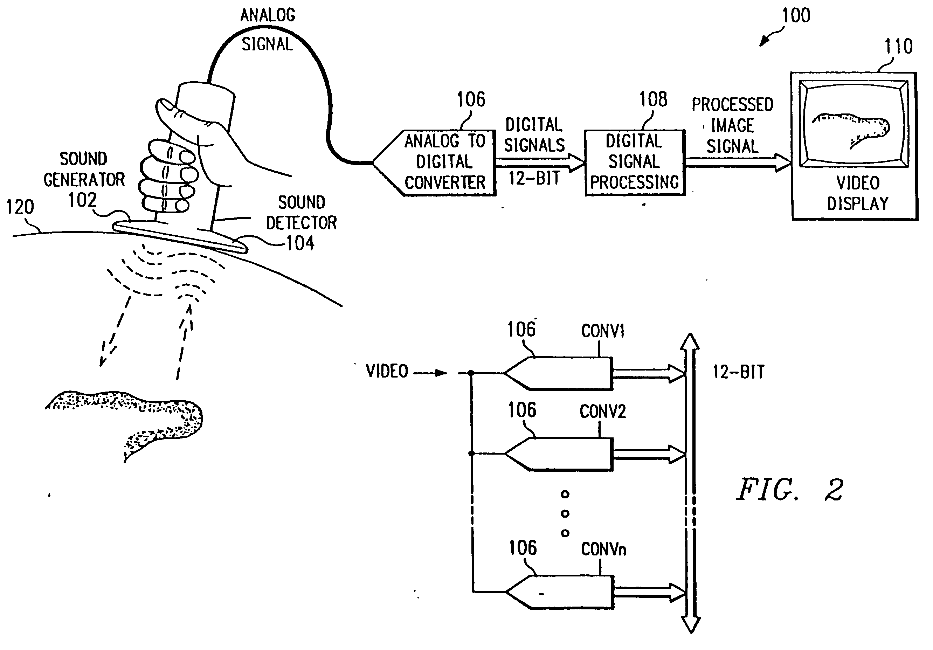

Figure 1 schematically illustrates an ultrasound analysis system 100 which includes a sound generator 102, sound detector 104, first preferred embodiment analog-to-digital converter 106, digital signal processor 108, and video display 110. System 100 generates high frequency (100 KHz) sound waves that penetrate object 120, and these waves reflect from interior structures of object 120 to be detected by detector 104. Converter 106 converts the detected analog signal to a digital form for signal processing by DSP 108, and video display 110 presents the results on a CRT. Mechanically the scanning sound generator 102 and detector 104 over the surface of object 120 provide reflection information to reconstruct an image of the interior structure. Use of system 100 for human medical diagnosis or analysis demands relatively high speed operation for patient convenience and relatively high resolution for image reconstruction.

Converter 106 is a 12-bit, subranging (half-flash or two-step) converter with digital error correction which samples an analog input in the range of -2.5 volts to +2.5 volts at a sampling rate of 3 Msps (million samples per second) and with an input bandwidth of 30 MHz. 12-bit resolution implies that the least significant bit of output corresponds to a 1.22 mV input interval. An input bandwidth of 30 MHz means that converter 106 can track video signals and that an array of converters 106 with sequential clocking can provide video digitization; see Figure 2 which shows n converters 106 clocked by sequential commands CONV1, CONV2, ... CONVn. This array gives an effective sampling rate of 3n MHz.

Converter 106 operates over a temperature range of -55 C to +125 C with integral and differential linearity error and full scale error all about or less than 1 bit. Converter 106 uses a combination of bipolar and CMOS (BiCMOS) devices together with polysilicon-polysilicon capacitors and nickel-chromium thin film resistors plus laser trimming. Most CMOS gate lengths are about 1 $\mu$m and NPN emitters typically are about 2 $\mu$m by 3 $\mu$m with multiple devices paralleled to provide larger emitter areas. Also, matched devices may be split and laid out in symmetrical arrangements to help thermal balance and insensitivity.

Converter overview

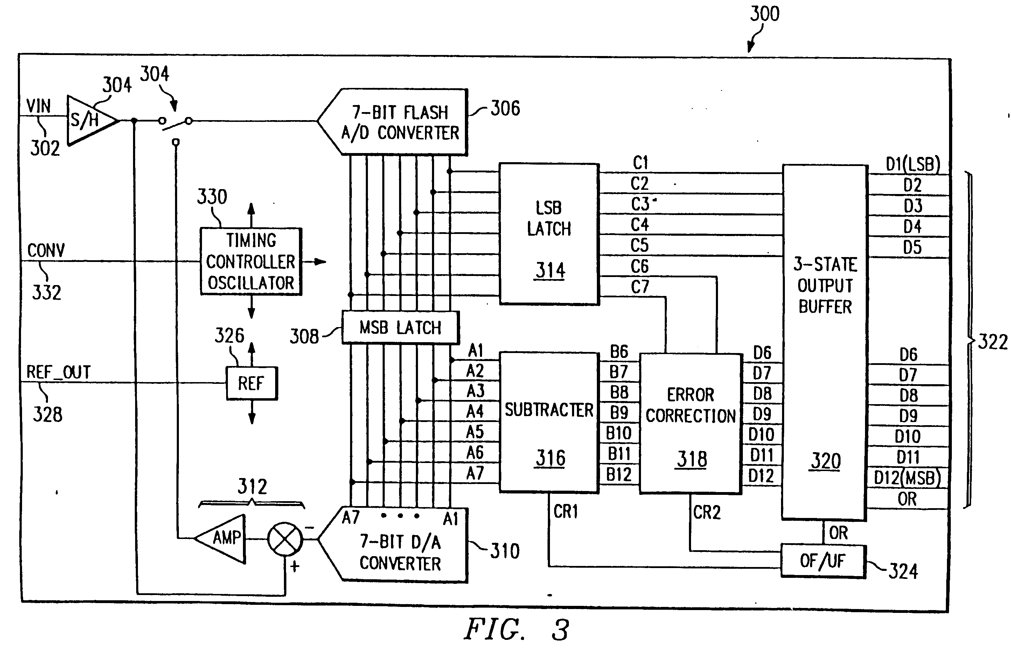

Figure 3 is a functional block diagram of the first preferred embodiment converter, indicated generally by reference numeral 300, which includes analog signal input terminal 302, sample and hold block 304, 7-bit flash analog-to-digital converter block 306, most-significant-bits (MSB) latch 308, 7-bit digital-to-analog converter (DAC) block 310 (the DAC is trimmed to more than 14-bit accuracy), error amplifier 312, least-significant-bits (LSB) latch 314, subtractor 316, error correction block 318, output buffer 320, output port 322, overflow/underflow block OF/UF 324, voltage reference block 326 with output terminal 328, timing controller and oscillator block 330, conversion command input terminal 332, and analog switch 334. Converter 300 is a two-step subranging analog-to-digital converter which uses the same 7-bit flash converter for both the MSB and the LSB conversions. Correction of device errors makes use of MSB and LSB overlap. The 12-bit output uses a two's complement representation of negative numbers, so an input of 0 volts leads to an output of 1000 0000 0000, an input of -1.22 mV gives an output of 0111 1111 1111, and an input of -2.5 volts yields 0000 0000 0000. An input of +1.22 mV gives an output of 1000 0000 0001, and an input of +2.5 volts yields 1111 1111 1111.

Operation summary

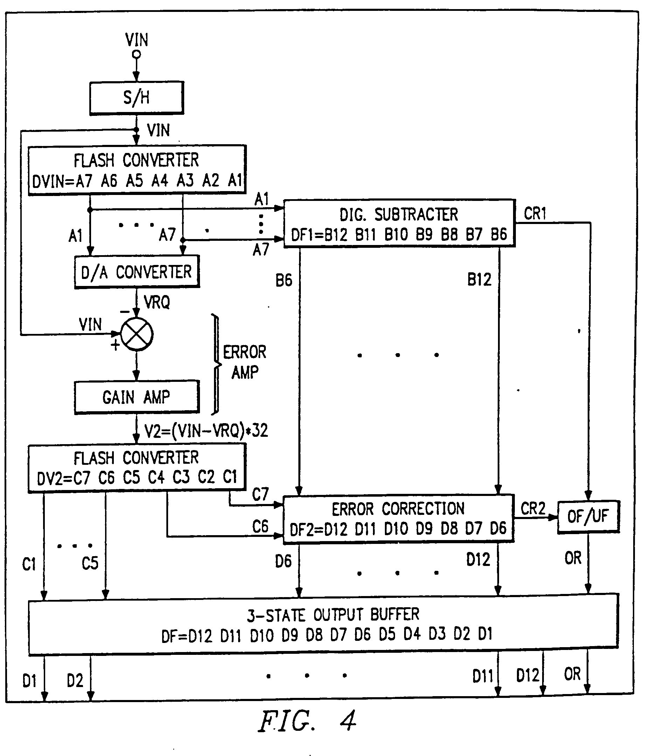

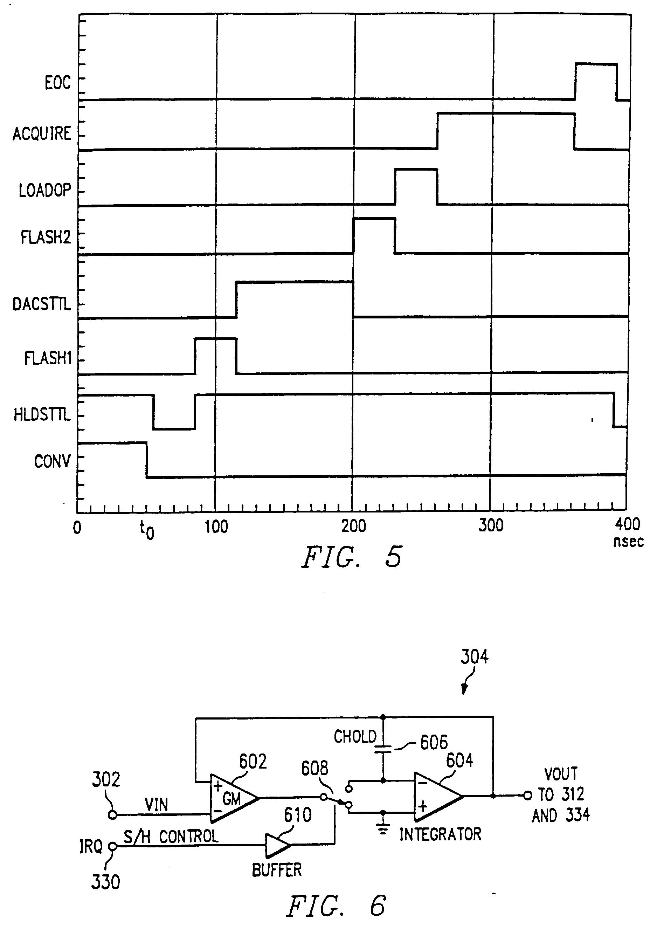

Figure 4 is a flow diagram for a conversion by converter 300 and Figure 5 is a timing diagram (in nanoseconds) for the conversion flow which basically proceeds as follows. A falling edge of the convert command (CONV) input at terminal 332 begins the conversion process; see the bottom panel of Figure 5. Just prior to the CONV command, sample and hold 304 was tracking (following) the input $V_{in}(t)$ at terminal 302, analog switch 334 was connecting the output of sample and hold 304 to flash converter 306, the comparators and encoder of flash converter 306 were following the sample and hold 304 output (which ideally is $V_{in}(t)$) but without latching, DAC 310 was holding at a 0 volt output due to a fixed input, and error amplifier 312 was clamped to a 0 volt output. The CONV command at time $t_0$ switches sample and hold 304 into the hold mode and with a fixed output equal to $V_{in}(t_0)$. This switching requires a settling time of about 30 nanoseconds (nsec) due to charge injection by the switch; see the HLDSTTL pulse in the second panel from the bottom of Figure 5. For simplicity, $V_{in}(t_0)$ will be called $V_{in}$. At the end of the HLDSTTL pulse, the first flash convert clock FLASH1 rises to latch the comparators of flash converter 306 which have been following the essentially constant output $V_{in}$ of sample and hold 304. The comparators ideally are outputting a quantization of $V_{in}$ to the encoder which has been encoding this quantization as a 7-bit number; see the FLASH1 pulse in the third from bottom panel of Figure 5. After about 28 nsec to allow settling by the latching circuitry of flash converter 306, the FLASH1 pulse falls low to store the 7-bit output in MSB latch 308 (not shown in Figure 4 but incorporated in Digital Subtractor and Error Correction). This 7-bit output is the binary encoding of the quantized version of the input signal $V_{in}$ with quantization levels separated by about 39 mV. Because the final 12-bit output of converter 300 will be a binary encoding of the quantized version of $V_{in}$ with quantization levels separated by 1.22 mV (39 mV divided by 32), this 7-bit output contributes only to the seven most significant bits of the find 12-bit output. Note that an output of 0000000 from flash converter 306 corresponds to an input signal of about -2.5 volts, whereas an input signal of about 0 volts will lead to an output of 1000000 and an input of about +2.5 volts will yield an output of 1111111.

Next, the rising edge of the 80 nsec DAC settling pulse (DACSTTL pulse in the fourth from bottom panel of Figure 5) performs three tasks: (1) it puts the 7-bit output of flash converter 306 stored in MSB latch 308 into DAC 310, which reconstructs the quantization of $V_{in}$ from the 7 bits, this reconstruction is denoted $V_{rq}$ below, (2) it puts the output of flash converter 306 into subtractor 316 which adds a fixed 7-bit code to compensate for the bipolar mode of operation and error correction, and (3) it switches analog switch 334 to connect the output of error amplifier 312 to the input of flash converter 306. Then the DAC 310 output begins slewing towards its final value, $V_{rq}$, and feeds an input of error amplifier 312 which, however, remains clamped for about 10 nsec to avoid noise and saturation problems. During the remaining 70 nsec of the DACSTTL pulse, DAC 310 settles to its final output $V_{rq}$ and error amplifier 312 amplifies the difference between $V_{in}$ and $V_{rq}$ by a factor of 32. That is, error amplifier 312 amplifies the quantization error by 32; see the left middle portion of Figure 4.

The second step conversion begins at the end of the DACSTTL pulse: flash converter 306 has been following the output of error amplifier 312 which has been settling to the amplified quantization error, and the rising edge of the second flash convert pulse (FLASH2 in the fifth from bottom panel of Figure 5) latches the comparators of flash converter 306. The falling edge of FLASH2 28 nsec later stores the encoded quantized version of the amplified quantization error in LSB latch 314, which feeds the most significant two bits to error correction block 318. Due to the amplification factor being only 32, rather than 128 as 7-bit conversion would suggest, the second conversion's most significant bits overlap the first conversion's least significant bits.

If the components of converter 300 were errorless, then the overall conversion would amount to the following. The first flash conversion effectively decomposes $V_{in}$ as

$$V_{in} = V_q + (V_{in} - V_q)$$

where $V_q$ is the quantized version of $V_{in}$ with quantization levels separated by about 39 mV and $(V_{in} - V_q)$ is the first quantization error. The 7-bit output in MSB Latch encodes $V_q$. DAC 310 errorlessly reconstructs $V_q$ from the 7 bits in MSB Latch 308; that is, $V_{rq}$ equals $V_q$. Next, the second flash conversion effectively decomposes the amplified first quantization error $32(V_{in} - V_q)$ as

$$32(V_{in} - V_q) = W_q + [32(V_{in} - V_q) - W_q]$$

where $W_q$ is the quantized version of $32(V_{in} - V_q)$. Again the quantization levels are separated by about 39 mV and $[32(V_{in} - V_q) - W_q]$ is the second quantization error. The 7-bit output in LSB Latch encodes $W_q$. So the final quantized output is $V_q + W_q/32$ with roughly $V_q$ generating the most significant bits and $W_q/32$ the least significant bits. Thus the combined effect of both flash conversions is to decompose $V_{in}$ as

$$V_{in} = V_q + W_q/32 + [32(V_{in} - V_q) - W_q]/32$$

That is, the overall quantization error equals the second quantization error divided by 32; so the overall quantization error is at most 39mV/32 which equals 1.22 mV.

Error correction block 318 corrects any dynamic error (within tolerance) caused by the limited linearity accuracy of flash converter 306 during the first conversion step; the two most significant bits of the second conversion overlap the two least significant bits of the first conversion and provide the basis for the correction. Error correction block 318 provides the seven most significant bits and LSB latch 314 the five least significant bits to 12-bit output buffer 320 which makes the bits available at output port 322. Error correction and output buffer 320 loading consume about 20 nsec; see the LOADOP pulse in the sixth from bottom panel of Figure 5. This completes the overall conversion; and if CONV remains low, another sampling and conversion begins. The seventh from bottom panel of Figure 5 shows the ACQUIRE pulse which activates sample and hold 304 to acquire another sample, and the eighth from bottom panel (the top panel) of Figure 5 shows the End of Conversion pulse EOC. The settling time for sample and hold 304 after switching from hold mode to sample mode is about 100 nsec and uses both the 80 nsec ACQUIRE pulse and the 20 nsec EOC pulse. The righthand portion of the second from bottom panel of Figure 5 indicates the HLDSTTL pulse of the next conversion.

The analog signal input range is 5 volts (-2.5 volts to +2.5 volts), so the quantization, 7-bit encoding, and subsequent analog reconstruction of input signal $V_{in}$ will ideally yield a quantized approximation $V_{rq}$ with level spacings of 39.0625 mV and such that the approximation only differs from the input signal by at most one-half of a level spacing (19.53125 mV). Hence the difference, $V_{in} - V_{rq}$, after amplification by a factor of 32 in error amplifier 312, will ideally fall in the range of -625 mV to +625 mV and thus not exceed one quarter of the input range of flash converter 306. Therefore, the output of the second pass through flash converter 306 should be seven bits with the three most significant bits being either 011 or 100 for negative or positive inputs, respectively. Consequently, the two most significant bits of the second pass overlap the two least significant bits of the first pass through flash converter 306, and this implies a 12-bit overall output rather than a 14-bit output as would have been guessed from the two 7-bit conversions. Discussion of error correction block 318 below details this overlapping of bits and also leads to overflow/underflow block 324 which indicates an original input out of the -2.5 to +2.5 volts range.

Converter 300 has the following features: the timing pulses driving the operation do not overlap; only one function runs at a time, which lessens noise coupling; the sample and hold control provides aperture delay of less than 20 nanoseconds and aperture jitter of less than 25 picoseconds; clock signals driving flash converter 306 are translated to bipolar levels with a swing of 0.7 volts ($V_{be}$) and lessen switching noise; subtractor 316 completes its operation prior to the activation of error amplifier 312 to lessen noise problems and avoid overdrive; the switching delay in activation of error amplifier 312 permits a settling of the DAC 310 output; and the output buffer 320 turns on its drivers sequentially to lessen ground bounce. The small aperture jitter permits the parallel configuration of converters, as illustrated in Figure 2.

Converter 300 uses separate digital and analog power supplies and digital and analog grounds. The power supplies Vcc and Vdd are at +5 volts and Vee and Vss are at -5 volts with analog bipolar and CMOS devices operating between +5 and -5 volts but with the digital CMOS devices operating between +5 volts and ground.

Figures 6-22 illustrate the elements of converter 300 in greater detail, including elements only implicitly shown in Figure 3; and the accompanying description follows the same order as the preceding overview.

Sample and Hold

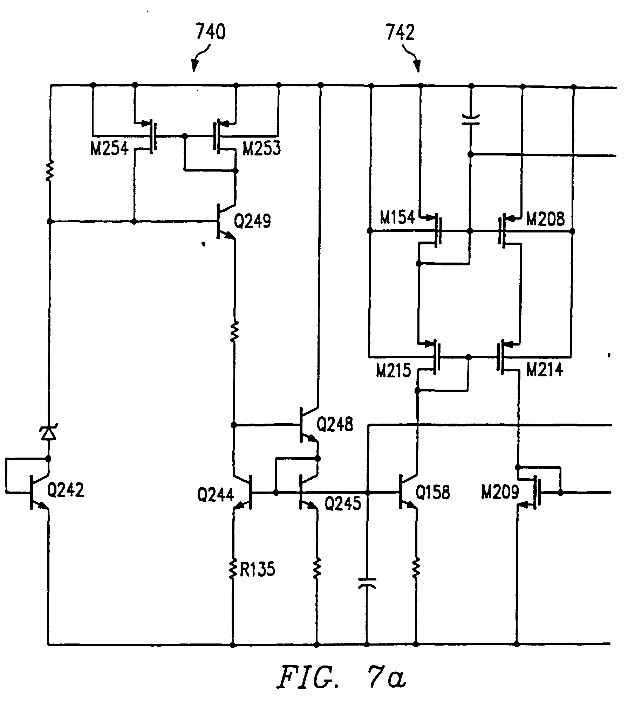

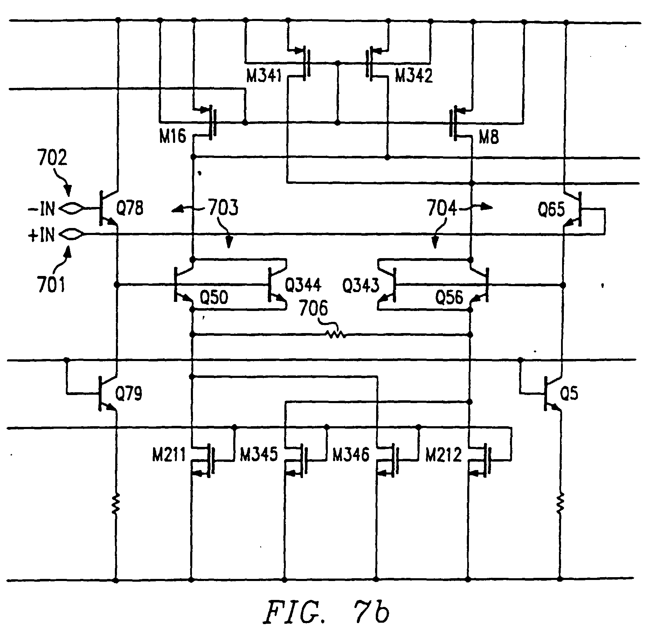

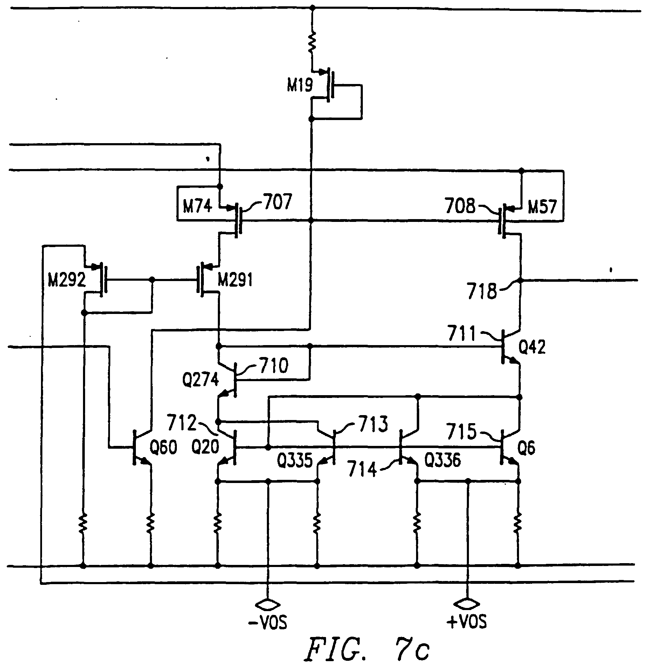

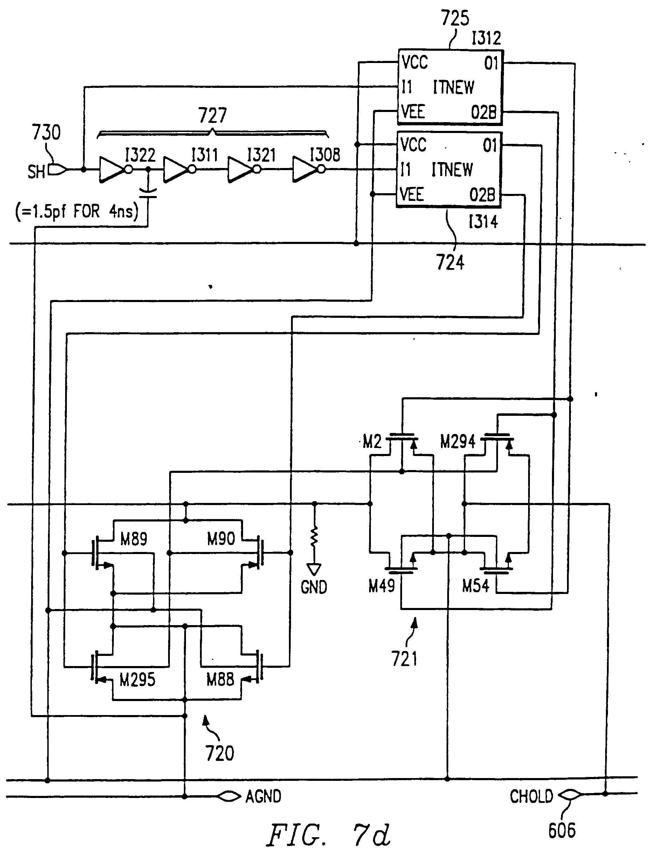

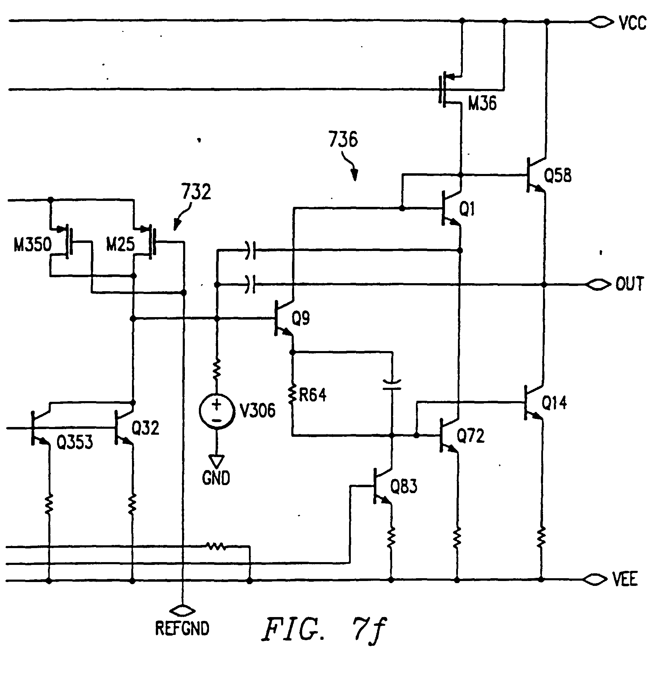

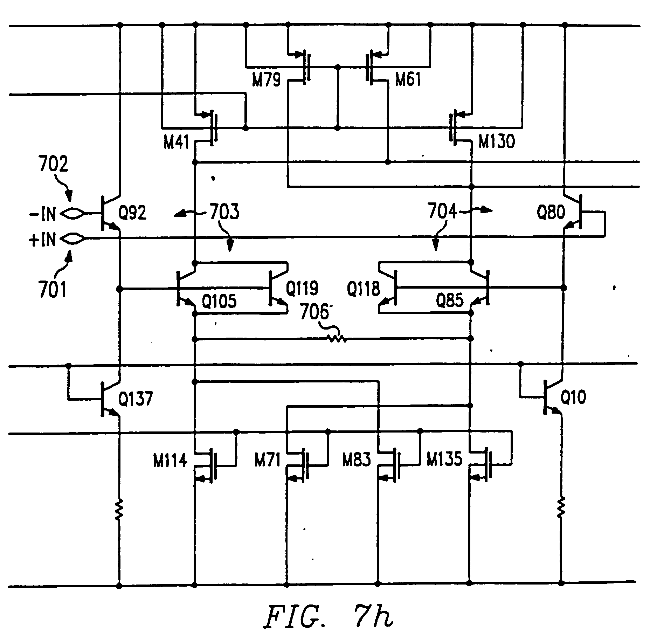

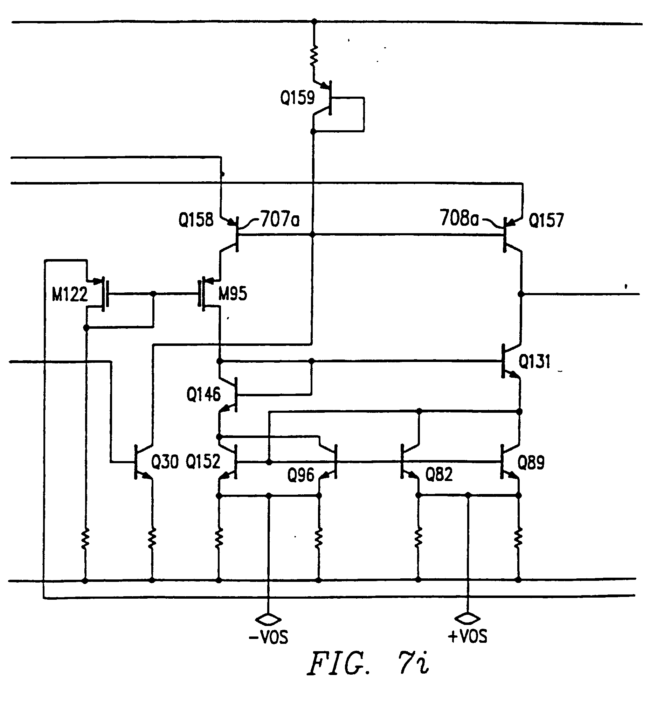

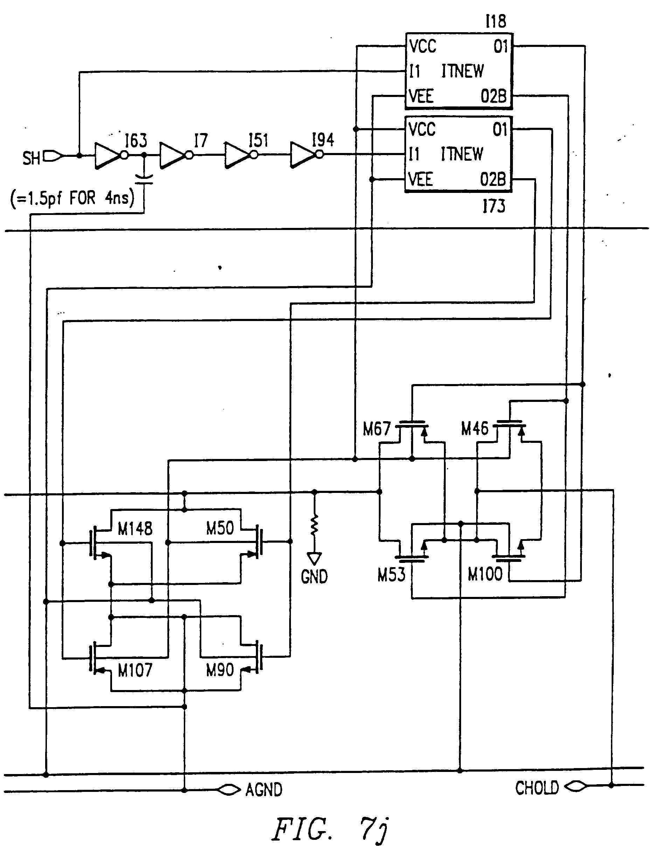

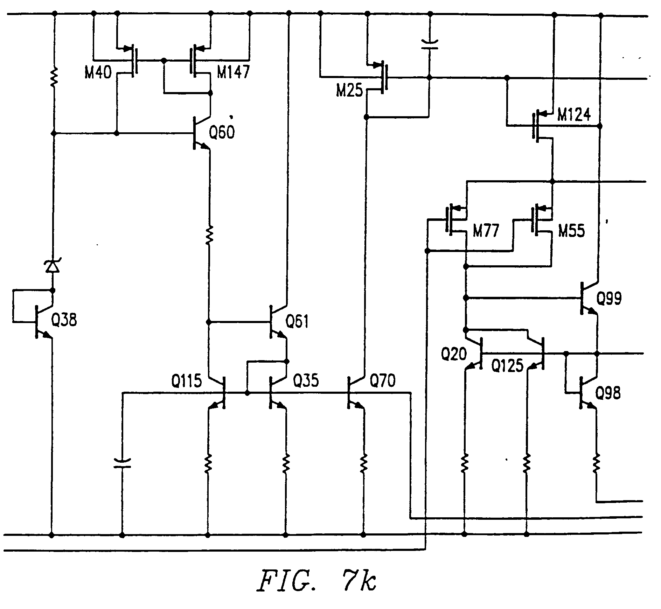

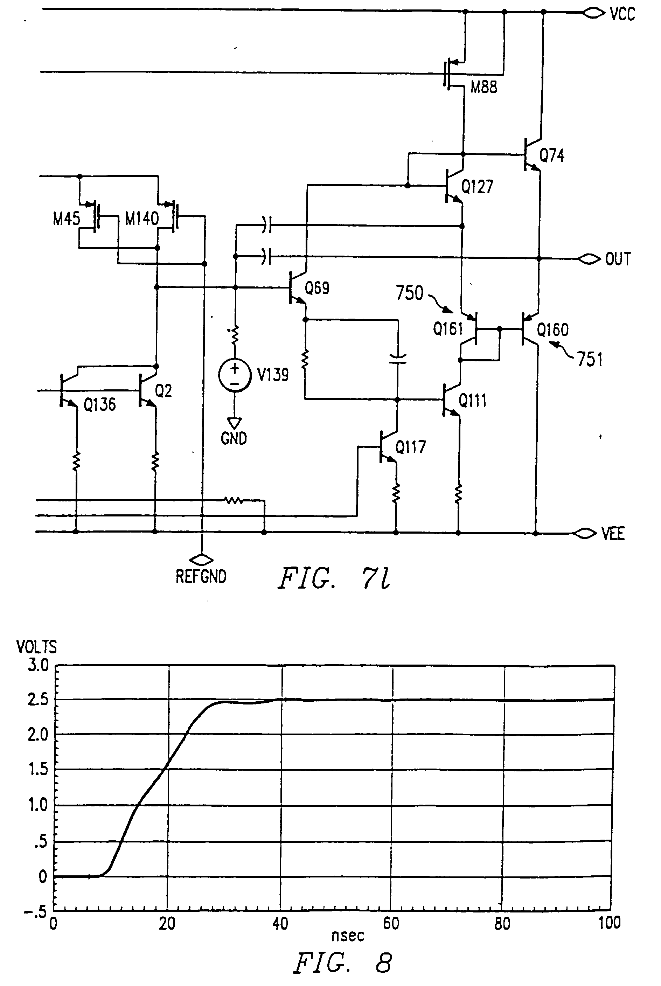

Figures 6-7f schematically show circuitry of sample and hold block 304 with Figure 6 providing a functional block diagram and Figures 7a-f a schematic circuit diagram. Figure 8 shows settling from a 2.5 volt input step function. As seen in Figure 6, sample and hold 304 includes differential amplifier 602, differential amplifier 604, and capacitor 606 arranged as a closed-loop integrating type sample and hold circuit. Timing controller block 330 controls switch 608 through buffer 610.

In the sample mode, switch 608 connects the output of amplifier 602 to the inverting input of amplifier 604 which charges or discharges capacitor 606 so that the output Vout tracks the input $V_{in}$ at terminal 302. During hold mode switch 608 connects the output of amplifier 602 to ground to prevent saturation, and amplifier 604 holds the charge on capacitor 606 and also drives the bipolar input of error amplifier 312 and, when analog switch 334 is thrown, the bipolar input of flash converter 306.

NPN devices are used in the input amplifier where device matching, high speed, and large transconductance are needed. MOS transistors are used in the sample and hold switch where their low off-state leakage, fast switching speed, and charge injection compensation ensure low pedestal error and fast hold mode settling. The high input impedance of MOS transistors is utilized in the input stage of the output amplifier. The high input impedance provides a very low droop rate. The high speed characteristics of the bipolar transistors are utilized in the rest of the output amplifier (gain and output stages) to achieve a large bandwidth which translates into low acquisition times.

Figures 7a-f show amplifier 602 as a high output impedance transconductance amplifier. The inputs 701-702 connect to a modified Darlington differential pair 703-704 with emitter degeneration resistor 706 for improved slew rate; the inputs (which are $V_{in}$ and Vout) are to be in the range of -2.5 to +2.5 volts and the rails are at +5 volts and -5 volts. The outputs of the differential pair 703-704 connect to the sources of PMOS cascode devices 707-708 which replace PNP devices and provide a high frequency level shift function and drive the Wilson current mirror made of NPNs 710-715. The single-ended output of amplifier 602 at node 718 connects to sample and hold switch 608 which consists of a pair of CMOS transmission gates 720-721, gate 720 connects output node 718 to ground and gate 721 connects output node 718 to inverting input 731 of amplifier 604 and capacitor 606. The CMOS transmission gate switch includes charge cancelling devices to reduce charge injection error and leakage current. The switch control signal (called IRQ below) from block 330 enters node 730 and directly drives level translator 725 to switch gate 721 but is delayed by inverter chain 727 for driving level translator 724 to switch gate 720. Hence, switching from sample mode to hold mode has a few nsec gap between the disconnection of the output of amplifier 602 from the inverting input of amplifier 604 to the connection of the output to ground. This gap avoids injecting charge from the switching to ground into holding capacitor 606 and thus lessens pedestal error.

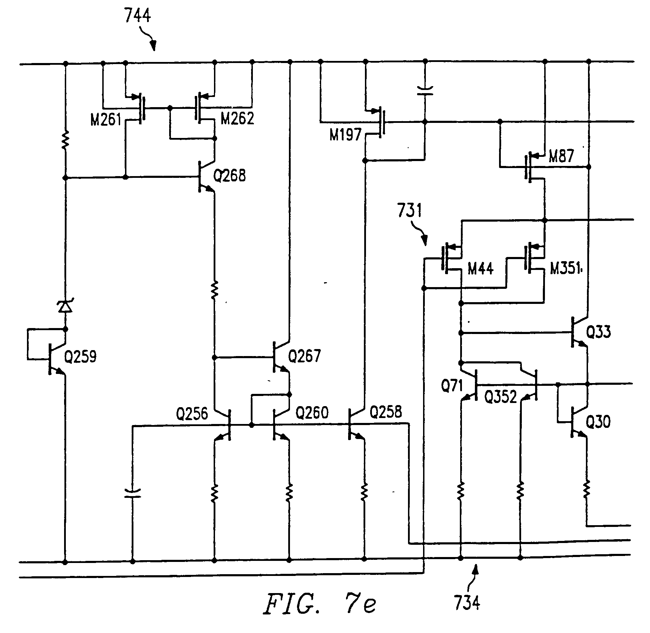

Amplifier 604 is a two gain stage amplifier with a large PMOS source-coupled pair used as an input differential pair 731-732 to provide high input impedance, low noise, and no dc gate current and using a NPN current mirror load 734. The single-ended output of the PMOS pair 731-732 drives an all-NPN output stage 736. Figures 7a,e also show start up circuit 740, bias circuit 742 for amplifier 602, and bias circuit 744 for amplifier 604; the use of separate bias circuits limits noise and talkback.

Capacitor 606 has 15 pF capacitance and is made of two layers of polysilicon separated by a grown oxide of 900 Å thickness for low leakage. Both amplifier 602 and amplifier 604 are made of a combination of CMOS and NPN devices, which permits the fast, high gain of amplifier 602 (input impedance of about 20 Mohms) and the low leakage input of amplifier 604 during the hold mode. The high gain plus the grounding of amplifier 602 during hold mode to prevent saturation (the input at $V_{in}$ keeps changing whereas Vout holds, so the differential input can become large) permits an acquisition time of less than 100 nsec for 0.01% error; that is, after switching to sample mode Vout tracks within 0.5 mV of $V_{in}$ within 100 nsec. See Figure 8, which illustrates the extreme case of $V_{out}$ initially at 0 volts and $V_{in}$ at +2.5 volts. The droop rate is less than 1 mV/μsec.

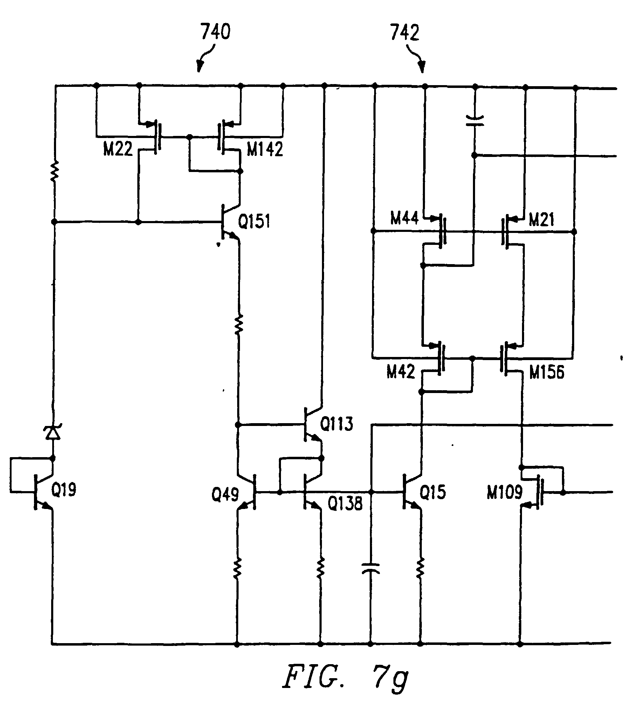

Figures 7g-l illustrate an alternate embodiment of the sample and hold 304 using PNP transistors. The PMOS cascode devices 707 and 708 are replaced with PNP bipolar transistors 707A and 708A to exploit their superior frequency response. The greater transconductance of the PNP transistor presents a lower impedance to the collectors of the input transistors 703 and 704, which reduces the parasitic time constant and improves acquisition time. A push-pull type output stage is made possible by the addition of the complementary PNP transistors 750 and 751. This type of output stage is capable of driving lower impedance loads. For a given load, the addition of the PNP will reduce phase shift in the output stage and allow a greater overall bandwidth.

The following table compares the improved specifications of the preferred embodiment sample and hold amplifiers to that presently available.

| Parameter | Prior Art | Figures 7a-f | Figures 7g-l |
|---|---|---|---|
| Input Range | ±10 V | ±2.5 V | ±2.5 V |
| Input Resistance | 15 Meg | 100K Ohms | 500K Ohms |
| Input Capacitance | <5 Pf | <5 Pf | <5 Pf |
| Input Offset | <1 mV | <1 mV | <1 mV |
| Input Bias Current | 500 na | 15 μa | <5 μa |
| Open Loop Gain | >160 dB | 150 dB | 180 dB |
| Unity Gain Bandwidth | 4 MHz | 30 MHz | 45 MHz |
| Acquisition Time | 500 nsec | 100 nsec | 50 nsec |
| Droop Rate | .1 mV/μsec | 1 mV/μsec | 1 mV/μsec |
| Slew Rate | 90 V/μsec | 130 V/μsec | 180 V/μsec |
| Pedestal Error | 2 mV | 1 mV | 1 mV |
| Hold Mode Settling, .8% | 100 nsec | 30 nsec | 20 nsec |
| Hold Mode Settling, .015% | 200 nsec | 60 nsec | 35 nsec |

Analog switch

Timing controller block 330 controls analog switch 334 which is a set of analog CMOS transmission gates. Analog switch 334 must be able to pass analog signals in the -2.5 to +2.5 volt range. With the power rails at -5 volts and +5 volts the analog CMOS transmission gates easily handle this range. Alternative switch implementations such as controlled CMOS inverters could also be used.

Flash converter

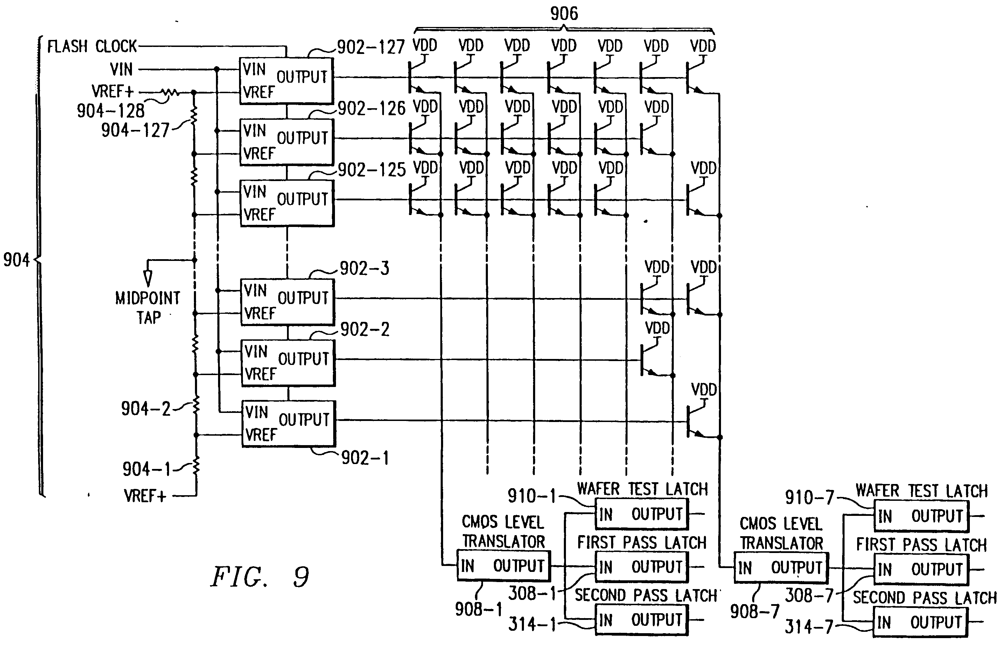

Figures 9-22 schematically show the 7-bit flash converter block 306. In particular, Figure 9 illustrates the overall flash architecture which includes an array of 127 comparator cells (labelled 902-1 through 902-127), each with a voltage reference input (Vref) connected to a tap on resistor ladder 904 and a signal input $V_{in}$ connected to the signal to be converted (either the output of sample and hold 304 or the output of error amplifier 312). Adjacent comparator cells 902 are functionally interconnected so that only the cell which senses a Vref closest to the input signal $V_{in}$ will output a logic high to array 906. Encoder 906 generates a 7-bit binary output (at ECL levels) which corresponds to the Vref closest to $V_{in}$ Level translators 908-1 through 908-7 translate this to CMOS levels and feed MSB Latch cells 308-1 to 308-7 and LSB Latches cells 314-1 to 314-7. Latches 910-1 through 910-7 are for testing.

The 128 resistors (labelled 904-1 through 904-128) of ladder 904 each have a nominal resistance of 3.8 ohms.

The total resistance of ladder 904 is 486 ohms. With a 5-volt drop the ladder will draw about 10 mA and dissipate 50 mW. The resistors 904 are fabricated from polysilicon with a width of at least 40 um in order to avoid electromigration problems at the contacts. Voltage references (Vref = +2.5V and Vref = -2.5V) drive ladder 904' so that the drop across each resistor equals 39.0625 mV, corresponding to a least significant bit (LSB) output. To insure that 1000 000 will be the outcome of an input within 19.5 mV (1/2 LSB) of 0 volts, resistor 904-65 is center tapped to analog ground (e.g., by replacing resistor 904-65 with two pairs of parallel connected 3.8 ohm resistors connected in series and tapping the series connection). To compensate for this center tap of resistor 904-65, resistor 904-1 is replaced by a 1.9 ohm resistor (two 3.8 ohm resistors in parallel) and resistor 904-128 is replaced by a 5.7 ohm resistor (3.8 ohm and 1.9 ohm resistors in series). Thus, disregarding any comparator cell input bias curent, the Vref input to comparator cell 902-1 is -2.480 volts (-2.5 + 1/2 LSB); the Vref input to comparator cell 902-2 is 1 LSB higher than to cell 902-1; and so forth up to a Vref input to comparator cell 902-64 of -1/2 LSB, a Vref input to cell 902-65 of + 1/2 LSB, and continuing up to a Vref of 2.441 volts (2.5 - 3/2 LSB) for cell 902-127.

The output of comparator cells 902 is encoded by encoder 906 which feeds seven level translators and latches 908-1 through 908-7. Only a single one of comparator cells 902 has a high output due to a segment detecting output NOR gate with inputs also from the two adjacent comparator cells; and encoder 906 is just a simple array of NPN transistors with bases tied to the comparator cell outputs and emitters tied to the seven bitlines feeding the level translators/latches 908. Thus when comparator cell 904-j has the high output, all of the NPN transistors in the jth row turn on and pull the connected bitlines up about 0.54 volts (from 4.46 volts to 5.0 volts) and thereby encode the output. Level translators 908 and latches 308 on the bitlines amplify and translate the 0.54 volt swings on the bitlines into full CMOS levels and latch them. The encoding expresses positive numbers with a leading bit equal to 1 and negative numbers in two's complement form with a leading bit equal to 0.

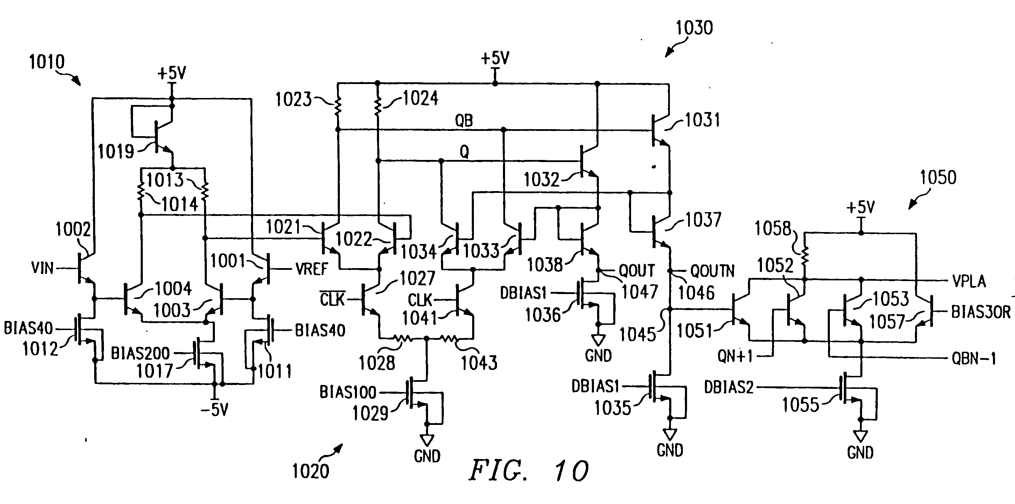

Figures 10a-b are a schematic circuit diagram for a comparator cell 902 which has first gain stage 1010, second gain stage 1020, latch 1030, and output NOR gate 1050. First gain stage 1010 includes NPN emitter-followers 1001 and 1002 for buffering the Vref and Vin input signals, respectively, to NPN differential pair 1003-1004, which have NMOS 1017 as their current source. NMOS 1011 and 1012 provide current sources, load resistors 1013 and 1014 are made of NiCr, and NPN 1019 is diode connected. The devices operate with +5 volt (Vcc) and -5 volt (Vee) power supplies.

The outputs of first gain stage 1010 are limited to a swing of about 2.0 volts. These feed the inputs of second gain stage 1020 which includes input NPN differential pair 1021-1022, NiCr load resistors 1023 and 1024, NPN switch 1027, resistor 1028, and NMOS current source 1029. Second stage 1020 operates with +5 volts and ground power supplies. The outputs of second stage 1020 drive latch 1030, formed with cross-coupled NPNs 1033-1034. NPN 1031 provides the coupling from the collector of NPN 1033 to the base of NPN 1034. NPN 1032 couples the collector of NPN 1034 to the base of NPN 1033. NMOS 1035 and 1036 are current sources for NPN 1031 and 1032, respectively. NPNs 1037 and 1038 provide diodes, NPN 1041 is a switch, and resistor 1043 connects NPN 1041 to current source 1029. The latch devices also operate with +5 volts and ground power supplies.

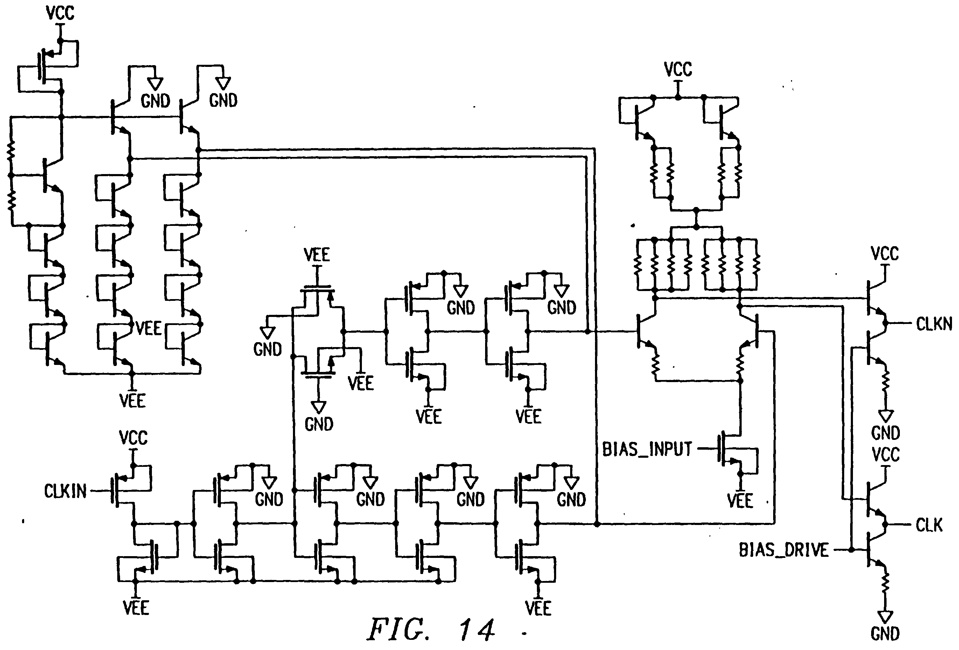

Second stage 1020 and latch 1030 operate as follows. The flash clock (the flash clock is the sum of FLASH1 and FLASH2) is translated to Vbe levels (see Figures 14a-b and CLK in Figure 10b) and drives the base of switch NPN 1041. The complement of the flash clock drives the base of switch NPN 1027. Thus, prior to a conversion, switch NPN 1027 is on and differential pair 1021-1022 is active but switch 1041 is off and cross-coupled pair 1033-1034 are inactive. However, NPNs 1031 and 1032 are both active and the result of the comparison of Vref with Vin (which may be varying) passes to NOR gate 1050 (to the base of NPN 1051) and to the NOR gates of the adjacent comparator cells. Once flash clock goes high, switch 1027 cuts off the current to differential pair 1021-1022 and turns on switch 1041. This activates cross coupled NPN 1033-1034 to latch in the most current result of the comparison, Note that the switching and latching involves only current switching in NPN devices, so the voltage swings stay down in the range of 0.5 volt and do not create as much noise as comparable CMOS logic switching.

Latch 1030 has three outputs: inverting nodes 1045 and 1046 and noninverting node 1047. Node 1045 is one of the three inputs for NOR gate 1050; inverting node 1046 is an input to the NOR gate of the adjacent comparator cell receiving a higher Vref; and noninverting node 1047 is an input to the NOR gate of the adjacent comparator cell receiving a lower Vref. NOR gate 1050 includes parallel pulldown NPNs 1051, 1052, and 1053, plus NMOS current source 1055, logic reference voltage input NPN 1057, and pullup resistor 1058. The output of NOR 1050 connects to a row of encoder 906. The input (base) of NPN 1051 connects to an inverting output (node 1045) of latch 1030, the input of NPN 1052 connects to an inverting output of the latch of the adjacent comparator cell with a lower Vref, and the input of NPN 1053 connects to the noninverting output of the adjacent comparator cell with a higher Vref. Hence, the output of NOR gate 1050 is logic low unless all three of NPNs 1051-1053 are turned off, and this provides a logical segment detection in comparators 902 as follows.

NOR gate 1050 in comparator cell 902-j is high precisely when its node 1045 is low and node 1045 from cell 902-(j-1) is also low and node 1045 from cell 902-(j+1) is high. This corresponds to $V_{in}$ being greater than Vref for cell 902-j (and Vref for cell 902-(j-1) which is lower) and being less than Vref for cell 902-(j+1). And in this case NOR gate 1050 of cell 902-j being high pulls the jth row of encoder 906 high which in turn pulls the appropriate coding columns high. The NOR gates in all other cells 902-k have at least one of NPNs 1051-1053 turned on to pull the kth row of encoder 906 low and thereby not affect any of the coding columns. The NOR gates 1050 also provide some error correction. The NOR gate outputs will only be high if Vin is greater than Vref for cells 902-(i-1) and 902-i and if Vin is less than Vref for cell 902-(i+1). This requirement on the states of three adjacent cells avoids having two adjacent cells output a logic high signal at the same time. Otherwise, if two adjacent cells have high outputs the resulting binary code could have a value of up to twice the correct value; the three input NOR gate prevents this from happening.

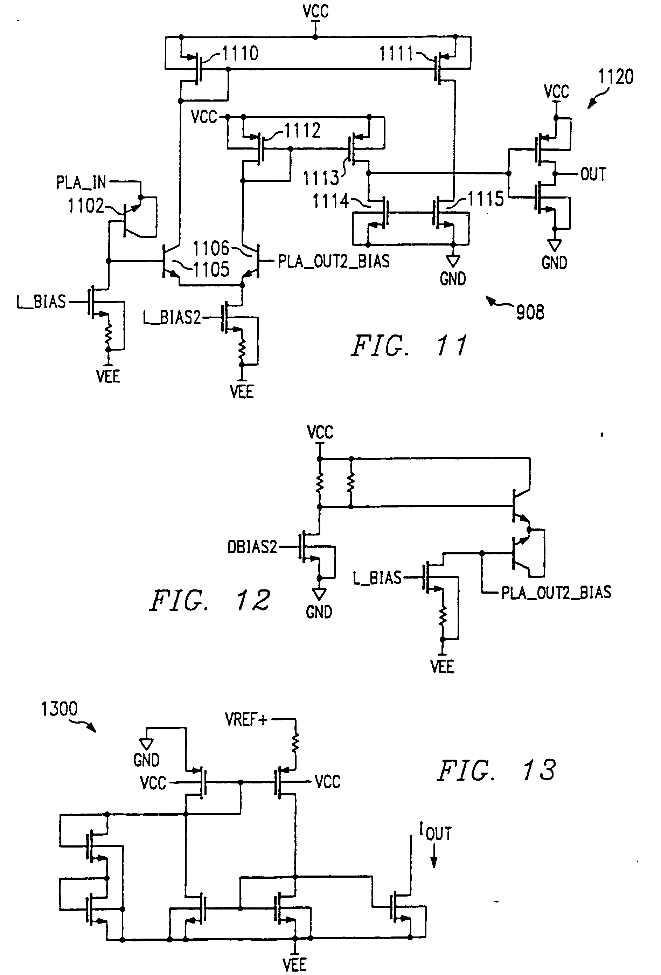

Figure 11 shows the circuitry for level translators 908-1 through 908-7. The corresponding column of encoding array 906 connects to diode 1102 into the base of NPN 1105 of differential pair 1105-1106. The base of NPN 1106 connects to a bias with level midway between the extremes of the swing at the base of NPN 1105. The currents through NPNs 1105-1106 are mirrored by PMOS mirrors 1110-1111 and 1112-1113 and then NMOS mirror 1114-1115 to drive a CMOS output inverter 1120. Figure 12 illustrates the bias circuit for NPN 1106.

Figure 13 shows bias generator 1300 for setting gate voltages in the comparator cells 902. Figures 14a-b show the clock generator for translating the CMOS level flash clock signal to +1/2 Vbe and -1/2 Vbe level signals for driving switch NPNs 1027 and 1041 in comparator cells 902.

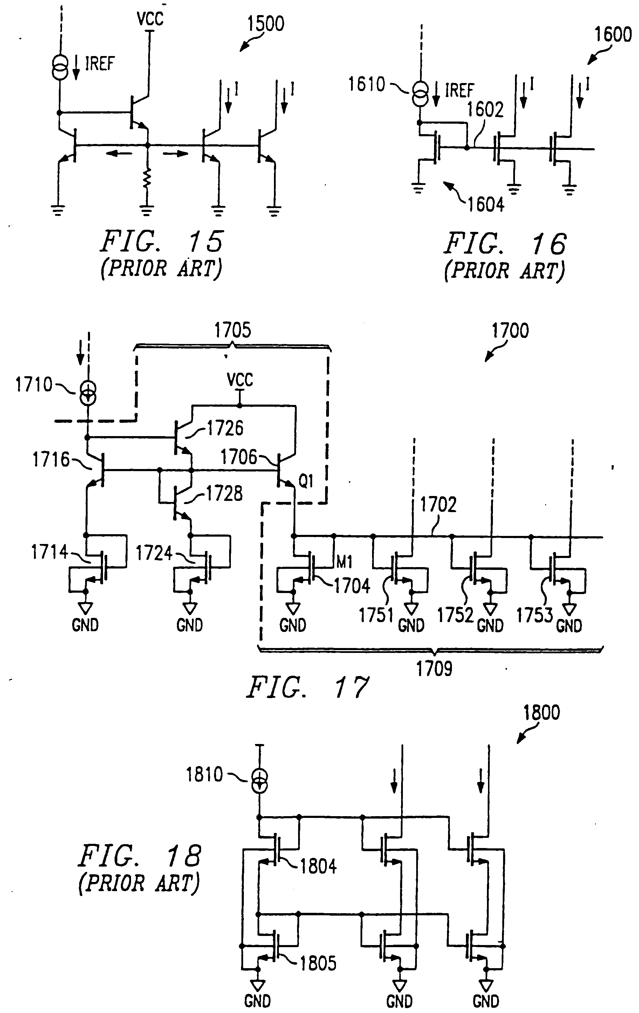

Each of the 127 comparator cells 902 has seven current source NMOS devices (1012, 1017, 1011, 1029, 1035, 1036, and 1055 in Figure 10). Thus a large number of equal parallel current sources must be provided to insure uniform behavior of the comparator cells. Figure 15 shows a standard base current compensated NPN current mirror 1500 with two outputs; the resistor current typically is an order of magnitude larger than the base currents. This current mirror overcomes base current error sensitivity of a basic NPN curent mirror, but has the drawback of having to provide a base current for every output NPN, which becomes intolerable for the 128x7 outputs required by the comparators 902. Figure 16 illustrates a basic NMOS current mirror 1600 which has the advantages of high packing density and zero bias current, and low drain to source operating voltages when a large number of outputs are required. However, the NMOS current mirror is sensitive to kickback noise. That is, a transient voltage spike at one of the outputs capacitively couples (i.e., a gate-to-drain parasitic capacitor) to gate bias line 1602. This causes a gate bias fluctuation and a current fluctuation in all of the other outputs. The magnitude of the gate bias fluctuation depends upon $Z/(Z+Z_{cap})$ where $Z_{cap}$ is the impedance of the gate-to-drain capacitor and Z is the impedance to ac ground of gate bias line 1602. In effect, a high pass filter exists between each output and gate bias line 1602 because $Z_{cap}$ varies as the reciprocal of frequency. The impedance Z is the reciprocal of the transconductance of NMOS 1604 if the impedance of reference current source 1610 and the output impedance of NMOS 1604 are large and neglected. Hence, the small transconductance of NMOS 1604 generally leads to the kickback noise sensitivity of the basic NMOS current mirror 1600.

The preferred embodiment current mirror 1700, shown schematically in Figure 17, inserts an NPN current mirror 1705 between reference current source 1710 and NMOS 1704 of an NMOS current mirror 1709. This lowers the impedance to ac ground of gate bias line 1702 because the high transconductance of NPN 1706 provides a path to ac ground paralleling NMOS 1704. An order of magnitude drop in the impedance may be easily achieved without a large increase in substrate area occupied by the devices. Thus current mirror 1700 can provide 20 dB further kickback noise rejection plus maintain the advantages of NMOS current mirrors.

The current mirror 1700 operates as follows. NMOS 1714 is matched with NMOS 1704 to provide the same voltage drop for equal currents. NPN 1716 and NPN 1726 match NPN 1706, so they form a base current compensated current mirror with matching NPN 1728 the shunt resistor. NMOS 1724 matches NMOS 1704 and 1714 to provide the same voltage drop. Thus the emitter current from NPN 1706 mirrors the reference current from source 1710 within a factor that can be taken as 1 presuming a large gain by NPN 1726. Output NMOS transistors 1751, 1752, 1753, etc. match NMOS 1704 and have the same gate bias, so the outputs mirror the reference current. Of course, the load devices 1724 and 1728 could be replaced by resistors, but this typically occupies more substrate area.

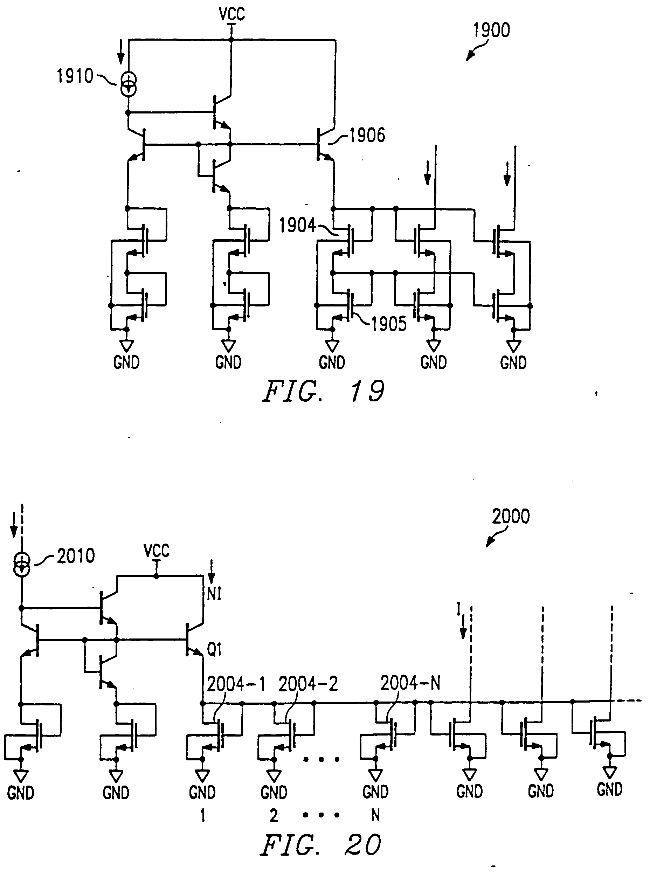

Current mirror 1700 can be modified in various ways to adapt these principles of kickback noise rejection to other MOS current mirror circuits. For example, Figure 18 shows a basic stacked NMOS current mirror as would be used for high output impedance applications with reference current source 1810 through NMOS 1804-1805 being mirrored by the output NMOS stacks. Figure 19 shows a preferred embodiment version 1900 of a stacked NMOS current mirror where NPN 1906 provides high transconductance to lessen kickback coupling. Indeed, simulations on the current mirrors 1800 and 1900 confirm that mirror 1900 provides 31 dB of additional kickback rejection.

Figure 20 illustrates a low current version of current mirror 1700. The reference current from source 2010 is divided among NMOS devices 2004-1, 2004-2, ... 2004-N so each device 2004-j outputs only 1/N of the reference current.

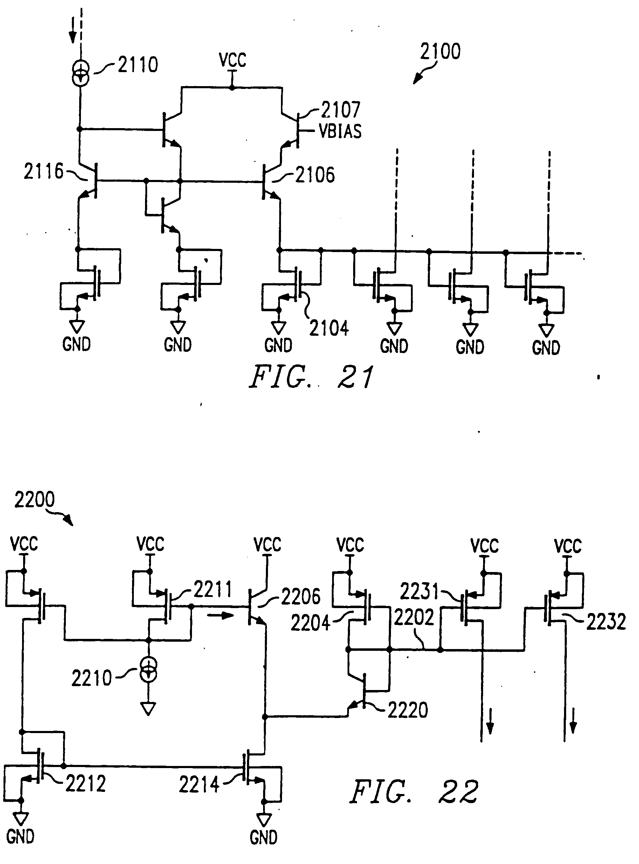

Figure 21 shows current mirror 2100 which modifies current mirror 1700 to compensate for the Early voltage induced errors of NPN 1706. Current mirror 2100 includes NPN 2107 with a fixed bias set to match the Vce of NPN 2106 to the Vce of NPN 2116.

Figure 22 illustrates a PMOS current mirror 2200 which includes the kickback suppression using NPNs. Current mirror 2200 provides the high transconductance of NPN 2206 in series with NPN 2220 to create the low impedance from gate bias line 2202 to ac ground. The reference current from source 2210 is mirrored into NMOS 2212 and then into NMOS 2214, which has twice the gate width of NMOS 2212. Thus twice the reference current passes through NMOS 2214. And NPN 2206 is biased by PMOS 2211 to pass the reference current. Consequently, PMOS 2204 and NPN 2220 also pass the reference current, and this is mirrored by output PMOS 2231 and 2232 through gate bias line 2202. NPN 2220 provides a Vbe voltage drop to match that of NPN 2206, and PMOS 2204 matches PMOS 2211.

Current mirror 1700 could be converted to a PMOS current mirror by replacing NPN with PNP and NMOS with PMOS. Similarly, the other current mirrors 1900, 2000, 2100, and 2200 could be transformed by P and N type device switches.

## Claims

1.  A current mirror, comprising:

    (a) a first stage comprising a reference current input for receiving a reference current,

    a first bipolar transistor coupled to the reference current input and having an emitter current representative of the reference current;
    voltage generating means for generating a voltage proportional to a current, said voltage generating means coupled to the emitter of the first bipolar transistor for generating a voltage proportional to the emitter current of the first bipolar transistor;
    a second bipolar transistor coupled to the first bipolar transistor and to the output of the first stage for generating at the emitter of the second bipolar transistor a controlled voltage representative of the reference current;

    (b) a second stage with a second stage input coupled to the output of the first stage, said second stage comprising one or more output field effect transistors (FETs) with their gates coupled to the controlled voltage for generating second stage output currents in the output FETs proportional to the controlled voltage of the first stage output and representative of the reference input current.

2.  The current mirror of claim 1 wherein the controlled voltage corresponds to the voltage generated by the voltage generating means.

3.  The current mirror of claim 1 wherein the bases of the first and second bipolar transistors are connected to each other.

4.  The current mirror of claim 1 wherein the two bipolar transistors are NPN transistors and the output FETs are NMOS transistors.

5.  The current mirror of claim 4 wherein the voltage generating means comprises a diode connected NMOS transistor.

6.  The current mirror of claim 1 wherein the two bipolar transistors are PNP transistors and the output FETs are PMOS transistors.

7.  The current mirror of claim 6 wherein the voltage generating means comprises a diode connected PMOS transistor.

8.  The current mirror of claim 1 wherein the second stage further comprises current generating means coupled to the emitter of the second bipolar transistor for generating a current proportional to the emitter voltage.

9.  The current mirror of claim 8 wherein the voltage generating means of the first stage and the current generating means of the second stage are identical FETs.

10. The current mirror of claim 8 wherein the current generating means comprises a diode connected NMOS transistor.

11. The current mirror of claim 10 wherein the gate and the drain of the current generating NMOS transistor are connected to the controlled voltage.

12. The current mirror of claim 8 wherein the current generating means comprises a diode connected PMOS transistor.

13. The current mirror of claim 12 wherein the gate and the drain of the current generating PMOS transistor are connected to the controlled voltage.

14. The current mirror of claim 1 wherein the first stage further comprises base compensation circuitry connected to the bases of the first and second bipolar transistors for compensating the base current of the first and second bipolar transistors.

15. The current mirror of claim 14 wherein the base compensation circuitry comprises a third bipolar transistor having its base coupled to the collector of the first transistor and its emitter coupled to the base of the second bipolar transistor.

16. The current mirror of claim 15 wherein the base compensation circuitry further comprises a fourth bipolar transistor in series with a FET for further compensating the base current in the first and second bipolar transistors.

17. The current mirror of claim 1 wherein the diode connected FET provides a first impedance path for spurious signals on the gates of the output FETS and the second bipolar transistor provides a second impedance path for such spurious gate signals, said second impedance path being substantially less than the impedance of the first impedance path.

18. The current mirror of claim 1 wherein each of the first bipolar transistor, the voltage generating means and each output FET is serially connected to a diode-connected FET.

19. A method of mirroring currents, comprising the steps of:

   providing first and second stages in a current mirror, said first stage comprising first and second bipolar transistors;
   providing an input reference current to the collector of the first bipolar transistor;
   generating a voltage at the emitter of the first transistor representative of the input reference current;
   generating a controlled output voltage at the emitter of the second bipolar transistor representative of the input reference current;
   connecting gates of one or more output FETs to the controlled voltage to provide one or more output currents representative of the input reference current.

20. The method of claim 19 wherein the voltage generated at the emitter of the first bipolar transistor corresponds to the controlled voltage at the emitter of the second bipolar transistor.

21. The method of claim 19 wherein the bipolar transistors are NPN transistors and the FETs are NMOS FETs.

22. The method of claim 19 wherein the bipolar transistors are PNP transistors and the FETs are PMOS FETs.

23. The method of claim 19 further comprising the step of generating a current proportional to the second emitter voltage.

ANALOG
SIGNAL

SOUND
GENERATOR
102

SOUND
DETECTOR
104

120

100

110

106
ANALOG TO DIGITAL CONVERTER

DIGITAL SIGNALS
12-BIT

108
DIGITAL SIGNAL PROCESSING

PROCESSED IMAGE SIGNAL

VIDEO DISPLAY

VIDEO

106 CONV1

106 CONV2

106 CONVn

12-BIT

FIG. 2

EP 0 901 058 A1

FIG. 3

VIN
○

S/H

↓ VIN

FLASH CONVERTER
DVIN=A7 A6 A5 A4 A3 A2 A1

A1 ... A7

A1
A7

DIG. SUBTRACTER
DF1=B12 B11 B10 B9 B8 B7 B6

CR1

D/A CONVERTER

B6

B12

VRQ

VIN

−

+

⊗

} ERROR AMP

GAIN AMP

V2=(VIN−VRQ)∗32

FLASH CONVERTER
DV2=C7 C6 C5 C4 C3 C2 C1

C7

C6

ERROR CORRECTION
DF2=D12 D11 D10 D9 D8 D7 D6

CR2

OF/UF

C1 ... C5

D6 ... D12

OR

3-STATE OUTPUT BUFFER
DF=D12 D11 D10 D9 D8 D7 D6 D5 D4 D3 D2 D1

D1 D2 ... D11 D12 OR

FIG. 4

FIG. 5

FIG. 6

FIG. 7a

FIG. 7b

FIG. 7c

FIG. 7d

744

FIG. 7e

734

FIG. 7f

FIG. 7g

FIG. 7h

FIG. 7i

FIG. 7j

FIG. 7k

FIG. 7l

FIG. 8

FIG. 9

FIG. 10

EP 0 901 058 A1

FIG. 11

FIG. 12

FIG. 13

FIG. 14

EP 0 901 058 A1

FIG. 15
(PRIOR ART)

FIG. 16
(PRIOR ART)

FIG. 17

FIG. 18
(PRIOR ART)

*FIG. 19*

*FIG. 20*

FIG. 21

FIG. 22

European Patent
Office

**EUROPEAN SEARCH REPORT**

Application Number

EP 98 11 5076

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US 4 792 750 A (YAN RAYMOND C) 20 December 1988 | 1-4,19 | G05F3/26 |
| A | * the whole document * | 5-18, 20-23 | |
| A | US 4 647 841 A (MILLER IRA) 3 March 1987 * the whole document * | 1-23 | |
| A | US 4 853 610 A (SCHADE JR HEINRICH) 1 August 1989 * the whole document * | 1-23 | |

TECHNICAL FIELDS
SEARCHED     (Int.Cl.6)

G05F

The present search report has been drawn up for all claims

| Place of search | Date of completion of the search | Examiner |
|---|---|---|
| THE HAGUE | 12 January 1999 | Schobert, D |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**ANNEX TO THE EUROPEAN SEARCH REPORT
ON EUROPEAN PATENT APPLICATION NO.**    EP 98 11 5076

This annex lists the patent family members relating to the patent documents cited in the above-mentioned European search report.
The members are as contained in the European Patent Office EDP file on
The European Patent Office is in no way liable for these particulars which are merely given for the purpose of information.

12-01-1999

| Patent document cited in search report | | Publication date | Patent family member(s) | Publication date |
|---|---|---|---|---|
| US 4792750 | A | 20-12-1988 | NONE | |
| US 4647841 | A | 03-03-1987 | NONE | |
| US 4853610 | A | 01-08-1989 | NONE | |

EPO FORM P0459

For more details about this annex : see Official Journal of the European Patent Office, No. 12/82